(19) Europäisches Patentamt
European Patent Office
Office européen des brevets

(11) EP 0 810 476 A1

(12) EUROPEAN PATENT APPLICATION

(43) Date of publication:
03.12.1997 Bulletin 1997/49

(51) Int. Cl.[6]: G03F 7/023, C08G 73/10

(21) Application number: 97108529.5

(22) Date of filing: 27.05.1997

(84) Designated Contracting States:
DE FR GB IT

(30) Priority: 27.05.1996 JP 132042/96

(71) Applicant:
HITACHI CHEMICAL CO., LTD.
Tokyo 163-04 (JP)

(72) Inventors:
- Okabe, Yoshiaki
Hitachi-shi, Ibaraki 317 (JP)
- Miwa, Takao
Hitachinaka-shi, Ibaraki 312 (JP)
- Maekawa, Yasunari
Hitachi-shi, Ibaraki 316 (JP)
- Ueno, Takumi
Mito-shi, Ibaraki 310 (JP)
- Geraldine, Rames-Langlade
Hitachi-shi, Ibaraki 316 (JP)
- Ishida, Mina
Hitachi-shi, Ibaraki 316 (JP)

(74) Representative:
Beetz & Partner
Patentanwälte
Steinsdorfstrasse 10
80538 München (DE)

# (54) Polyamic acid esters and positive type photosensitive resin compositions and their use for polyimide films for electronic devices

(57) The invention relates to novel polyamic acid esters having a hydrophobic group, highly reliable positive type photosensitive resin compositions which can be developed with an alkaline aqueous solution, and which comprise these polyamic acid esters, an o-quinonediazidesulfonyl amide compound, and/or an o-quinonediazidesulfonyl amide sulfonic ester compound, and electronic devices using the same. With these compositions, polyimide films having preferable positive type relief patterns, the unexposed portions of which are not corroded, can be obtained.

EP 0 810 476 A1

## Description

### Background of the Invention

The present invention relates to novel polyamic acid esters and their preparation and to positive type photosensitive resin compositions, which are suitable for using in electric or electronic devices, particularly in semiconductor devices, and which are developable by an alkaline aqueous solution.

Currently, polyimides have been widely used in the field of semiconductor, where strict reliability is required, because polyimides are superior in heat-resistance, mechanical strength, and electrical insulation properties compared to other materials.

As is well known, polyimides are utilized in the field of semiconductor devices as passivation films, buffer-coating films, $\alpha$-ray shielding films, insulating films between layers, and so on. In many cases, a process for manufacturing fine through-holes in polyimide films is necessary for forming a path through the upper and the lower conductive layers, or connecting external lead wires. Therefore, generally, a chemical etching treatment of the polyimide films using a photoresist is performed.

However, pattern formation of the polyimide film requires application and stripping of the photoresist, and a series of the process steps is complex. Therefore, photosensitive polyimides which are capable of being formed by a short process and of being manufactured finely, has been required. As the results of extensive developing efforts devoted by many manufacturers to meet this requirement, negative type photosensitive polyimides, which can be developed in an organic solvent, came to be commercialized. However, currently, in view of a high efficiency of facility and global environmental problems, positive type photosensitive polyimide, which do not need development in an organic solvent, but can be developed in an alkaline aqueous solution, have come to be required.

The positive type photosensitive polyimides can be divided into two categories: Polyimides in which a photosensitive group is introduced into the polyimide precursor (JP-B-1-59571 (1989)), and polyimides, to which a photosensitive group is added. As the latter positive type photosensitive polyimides of the photosensitive group addition type, the one composed of o-quinonediazidesulfonic acid ester (JP-A-4-168441 (1992), JP-A-4-204738 (1992)), which generates carboxylic acid by light irradiation, and the one composed of a polyimide precursor added with dihydroxypyridine derivatives (JP-A-6-43648 (1994), and others have been disclosed. However, all the above photosensitive polyimides have problems in resolution, sensitivity, and so on. The above o-quinonediazidesulfonic acid ester is a photosensitive agent and polyimide precursor used as photoresist, and both the dissolution prevention effect in the unexposed regions and the dissolution enhancing effect in the exposed regions of the photosensitive agent are insufficient.

Particularly, the positive type photosensitive polyimides have the special problem, which did not exist in the negative type, photosensitive polyimides, that the unexposed regions are corroded at their substrate portion in the developing process, because the exposed regions are dissolved in the case of the positive type photosensitive polyimides. As countermeasures for overcoming this problem, a method where a silane group coupling agent such as 3-aminopropylmethoxysilane is mixed into the photosensitive resin composition, and a method for improving the adhesiveness at the development by using surface treated substrates are well known. However, in case of semiconductor devices, a surface treatment is impossible, and adding a coupling agent to the photosensitive resin composition is also not so effective.

As explained above, various trials to confer positive type photosensitivity on polyimides which can be developed by an alkaline aqueous solution have been performed, but sufficient results could not be obtained.

### Summary of the Invention

It is one of the underlying problems of the present invention to provide novel polyamic acid esters suitable for being used in positive type photosensitive compositions, and a method for their preparation. A further underlying problem of the present invention is to provide positive type photosensitive resin compositions, which can be formed in a short-process, which are superior in the dissolution prevention effect in the unexposed regions and the dissolution enhancing effect in the exposed regions, which are capable of being manufactured finely, and which are of the alkaline development type having a high reliability and resolution, and to provide polyimides obtained from these polyamic acid esters and electronic devices using the same.

In view of the above object, the inventors studied extensively the solubility of various combinations of base polymers and photosensitive groups in an alkaline aqueous solution. As the result, it was found that polyamic acid esters (PAE), which are insoluble themselves in an alkaline aqueous solution, comprising a diamine containing carboxylic acid groups in a specific fraction in order to provide the PAE with an adequate solubility, and hydrophobic groups in order to obtain a clear relief pattern, are preferable as base polymers, because the boundary portions between the exposed regions and the unexposed portions are clearly separated, and fine manufacturing becomes possible.

Further, it was found that o-quinonediazidesulfonyl amide compounds or their sulfonic ester compounds, which change to indenecarboxylic acid, which is soluble in alkaline aqueous solutions, by light irradiation, are superior as photosensitive agents compared to conventional o-quinonediazidesulfonic acid esters, because the dissolution prevention

effect in the unexposed regions and the dissolution enhancing effect in the exposed regions are improved, and the high sensitivity allows exposure at low light doses.

Furthermore, it was found that a positive type photosensitive resin composition, which has a controlled solubility of exposed regions and is capable of forming clear relief patterns can be obtained by combining the above PAE and the o-quinonediazidesulfonyl amide compounds and/or their sulfonic ester compounds. The present invention is based on these findings.

The above underlying problems are solved according to the independent claims.

The dependent claims relate to preferred embodiments of the concept of the invention.

In accordance with a first aspect, the present invention relates to polyamic acid esters of the general formula I,

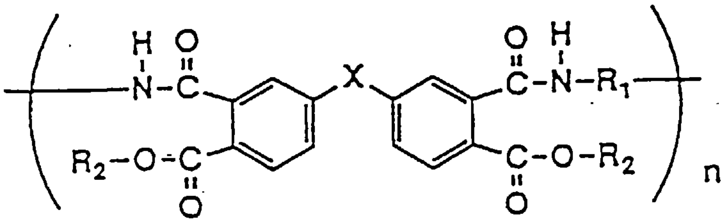

(I),

and/or of the general formula I',

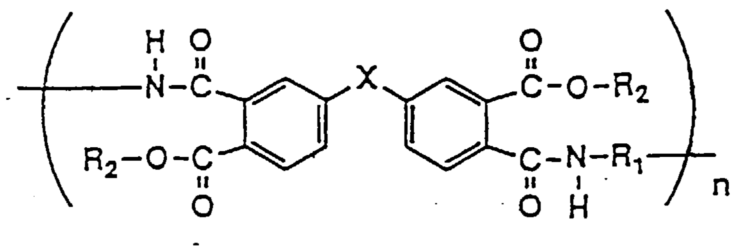

(I'),

and/or of the general formula I",

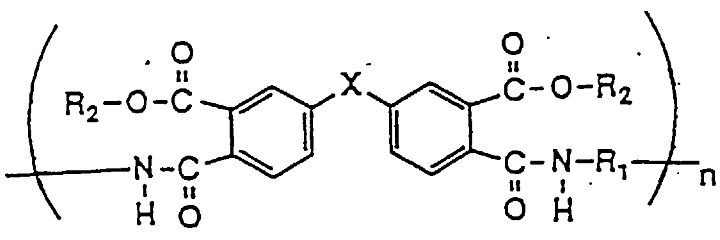

(I"),

in the above formulae I, I' and I" being
$R_1$ a divalent organic group,
$R_2$ a hydrophobic group,
X -O-, -CO- or a C-C single bond,
and
n an integer of at least 3,

with the proviso that more than 50 mol-% of the groups $R_1$ comprise one or more and preferably one or two carboxyl groups.

In accordance with a preferred embodiment, in the polyamic acid esters of formulae I, I' and/or I", 55 to 85 mol-% of the groups $R_1$ contain one or more and preferably one or two carboxyl groups.

According to a further preferred embodiment, in the polyamic acid esters of formulae I, I' and/or I'' n is an integer of at least 6, preferably of 6 to 1000, more preferably of 6 to 600, and still more preferably of 6 to 570.

In accordance with further preferred embodiments, the divalent organic groups $R_1$ not comprising carboxyl groups are selected from aliphatic, cycloaliphatic and/or aromatic groups which may be fluorinated, preferably from o-, m- and p-phenylene, diphenylether groups, terphenyl groups, bis(4-phenoxyphenyl)-sulfone groups, tolylene groups, benzophenone groups, 2,2'-bis(4-phenoxyphenyl)propane groups, bis[4-(4-phenoxy)-phenyl]sulfone groups, 2,2'-bis(4-phenoxyphenyl)hexafluoropropane groups, 1,3-bis(phenoxy)benzene groups and 2,2-bis(phenoxyphenyl)propane groups, all possible linkage positions (linkages to the amino groups) being included.

The divalent organic groups $R_1$ which contain one or more carboxyl groups are preferably selected from o-, m- and p-phenylene, diphenylether groups, terphenyl groups, bis(4-phenoxyphenyl)-sulfone groups, tolylene groups, benzophenone groups, 2,2'-bis(4-phenoxyphenyl)propane groups, bis[4-(4-phenoxy)-phenyl]sulfone groups, 2,2'-bis(4-phenoxyphenyl)hexafluoropropane groups, 1,3-bis(phenoxy)benzene groups and 2,2-bis(phenoxyphenyl)propane groups, all possible linkage positions (linkages to the amino groups) being included.

The hydrophobic groups $R_2$ are preferably selected from aliphatic, cycloaliphatic and/or aromatic hydrocarbon groups which may be fluorinated, preferably from $C_{3-12}$-alkyl groups and fluorinated $C_{3-12}$-alkyl groups.

According to a preferred embodiment, the polyamic acid esters have a weight average molecular weight, Mw, of 8000 to 200 000.

The polyamic acid esters of the present invention are optimally suited for positive type photosensitive resin compositions which can be developed by alkaline aqueous solutions.

The method of the invention for preparing the polyamic acid esters of formulae I, I' and/or I'' is characterized in that

- a tetracarboxylic acid dianhydride of the general formula IV,

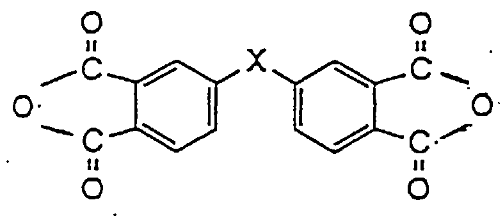

(IV),

wherein X is -O-, -CO- or a C-C single bond,
is allowed to react with an alcohol of the general formula V,

$$R_2\text{-}OH \qquad (V),$$

wherein $R_2$ is as defined above,
to obtain a tetracarboxylic acid ester,

- the carboxylic acid groups of the tetracarboxylic acid ester are converted into carboxylic acid chloride groups by a chlorinating agent, preferably thionyl chloride,
and
- the obtained tetracarboxylic acid ester chloride is allowed to react with a diamine of the general formula VI,

$$H_2N\text{-}R_1\text{-}NH_2 \qquad (VI),$$

wherein $R_1$ is as defined above, to obtain the polyamic acid ester of formulae I, I' and/or I''.

In accordance with a preferred embodiment of this method, the molar proportion of the alcohol of formula V, based on the molar amount of the tetracarboxylic acid dianhydride, is selected such that a diester is predominantly formed, related to the repeating unit of formulae I, I' or II'', respectively, in the average.

In a similar manner, it is preferred to select the molar proportion of the chlorinating agent and/or of the diamine of formula VI such that in the amide formation step, one diamine of formula VI is coupled per repeating unit in the average.

In the method of the present invention, it is further preferred to use a mixture of at least one diamine of formula VI not comprising carboxyl groups and at least one diamine of formula VI comprising one or more and preferably two carboxyl groups, the proportion of carboxyl-free and carboxyl-containing diamines being such that in the final product of formulae I, I' and/or I'' more than 50 mol-% and preferably 55 to 85 mol-% of the groups $R_1$ comprise one or more carboxyl groups and preferably one or two carboxyl groups.

The diamine of formula VI not comprising carboxyl groups is preferably selected from p-phenylenediamine, p,p'-diaminodiphenylether, p'-diaminoterphenyl, bis[4-(3-aminophenoxy)-phenyl]sulfone, 2,4-diaminotoluene, m,m'-diaminobenzophenone, m-phenylenediamine, 2,2'-bis[4-(p-aminophenoxy)-phenyl]propane, bis[4-(p-aminophenoxy)-phenyl]sulfone, 3,3'-diaminobenzophenone, 2,2'-bis[4-(3-aminophenoxy)-phenyl]hexafluoropropane, 1,3-bis(3-aminophenoxy)benzene and 2,2-bis[(3-aminophenoxy)-phenyl]propane.

The diamine of formula VI comprising one or more hydroxyl groups is preferably selected from 3,5-diaminobenzoic acid, 2,5-diaminobenzoic acid and 2,5-diaminoterephthalic acid.

In accordance with a further preferred embodiment of the above method, the alcohol of formula V is selected from propanol, butanol, pentanol, hexanol, heptanol, octanol, nonanol, decanol, undecanol and dodecanol, where the alcohol may be primary, secondary or tertiary, and the hydroxy group may be in an arbitrary position. It is also possible to use mixtures of alcohols of formula V.

In accordance with a second aspect, the present invention pertains to positive type photosensitive resin compositions, which can be developed by an alkaline aqueous solution, and which comprise

(A) one or more polyamic acid esters of formulae I, I' and/or I'' as defined above,

(B) an o-quinonediazidesulfonyl amide compound of the general formula II,

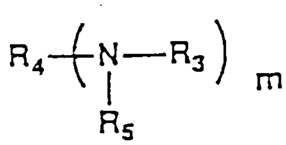

(II),

wherein are:

$R_3$ an o-quinonediazidesulfonic group,
$R_4$ an organic group of 2 to 30 carbon atoms,
$R_5$ an alkyl group or hydrogen,
and
m an integer of 1 to 6,
and/or

(C) an o-quinonediazidesulfonyl amide sulfonic ester compound of the general formula (III),

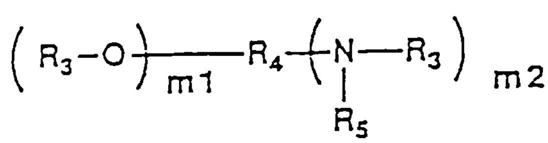

(III),

wherein are:

$R_3$ an o-quinonediazidesulfonic group,
$R_4$ an organic group of 2 to 30 carbon atoms,
$R_5$ an alkyl group or hydrogen,
$m_1$ an integer of 1 to 5,
and
$m_2$ an integer of 1 to 6.

The components (B) and (C) can also be used in the form of mixtures of two or more compounds.

In accordance with a preferred embodiment of the photosensitive resin composition according to the invention, the proportion (mixing ratio) of the o-quinonediazidesulfonyl amide compound (B) and/or the o-quinonediazidesulfonyl amide sulfonic ester compound (C)to the polyamic acid ester (A), is in the range of 5 to 45 and preferably in the range of 5 to 40 % by weight.

Further, the present invention relates to positive type photosensitive resin composition varnishes comprising the above positive type photosensitive resin composition and an organic solvent. The total concentration of the polyamic acid ester (A), the o-quinonediazidesulfonyl amide compound (B) and/or the o-quinonediazidesulfonyl amide sulfonic

ester compound (C) is preferably in the range of 5 to 45 % by weight and more preferably in the range of 5 to 40 % by weight.

Furthermore, the present invention relates to polyimide films obtained from the above positive type photosensitive resin compositions and varnishes.

Furthermore, the present invention relates to a method for manufacturing polyimide films comprising the steps of applying the above positive type photosensitive resin composition varnish onto a solid body, prebaking the coated solid body, exposing the solid body to light using a photomask having a desired pattern, etching/developing the exposed solid body with an alkaline solution, and heat treating the developed solid body.

Furthermore, the present invention relates to electronic apparatus and devices comprising the above polyimide films.

Accordingly, the present invention also deals with the use of the polyamic acid esters of formulae I, I' and/or I" for photosensitive resin compositions, corresponding varnishes, and photoresists, particularly for manufacturing electronic devices.

Hereinafter, details of the present invention are explained.

[1] Base polymer

The base polymer of the positive type photosensitive resin composition of the present invention is the polyamic acid ester (PAE) expressed by the following general formulae I, I' and/or I":

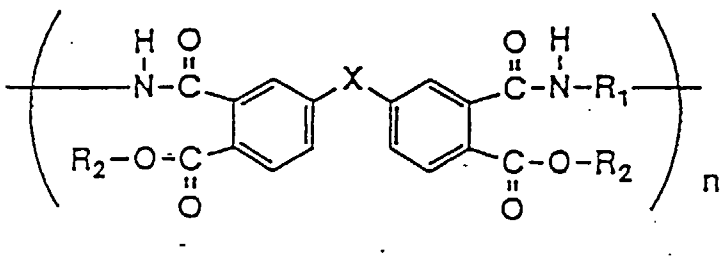

(I),

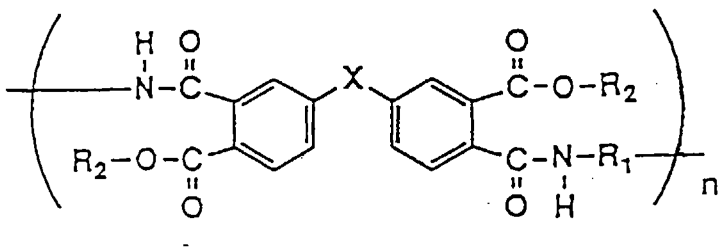

(I'),

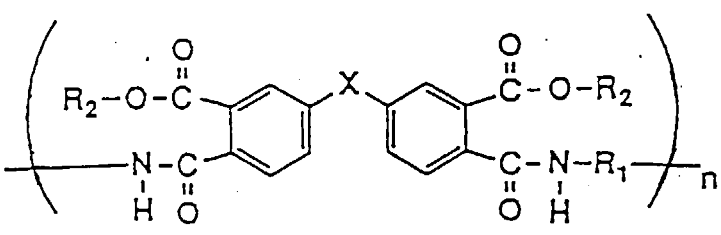

(I"),

in the above formulae I, I' and I" being

$R_1$ a divalent organic group,
$R_2$ a hydrophobic group,
X -O-, -CO- or a C-C single bond,
and

n an integer of at least 3,

with the proviso that more than 50 mol-% and preferably 55 to 85 mol-% of the groups $R_1$ comprise one or more and preferably one or two carboxyl groups.

n is preferably an integer of at least 6, more preferably of 6 to 1000, and still more preferably an integer of 6 to 600 and particularly of 6 to 570.

$R_1$ in the general formula (I) is the residue of a diamine, comprising adjacent N-H groups, and preferably 55 to 85 mol-% of the $R_1$, that is, 55 to 85 mol-% of the diamine, contain carboxyl groups. If the diamine containing the carboxylic group(s) is present in an amount of less than 55 mol-%, the solubility of the PAE in the alkaline aqueous solution is insufficient, and the developing time becomes long. On the contrary, if the proportion of the diamine containing the carboxylic group(s) is more than 85 mol-%, the solubility of the PAE in the alkaline aqueous solution is too large, and problems such as corrosion of the unexposed portions, and reduction of film thickness are generated.

$R_2$ in the general formula (I) is a hydrophobic group. Examples of the hydrophobic group-are, for instance, alkyl groups of 3 to 12 carbon atoms, cycloaliphatic hydrocarbon groups, aromatic groups, fluorinated alkyl groups, and the like. The PAEs having such hydrophobic groups are effective in forming preferable relief pattern at the development.

For instance, when the hydrophobic group is an alkyl group (an alkyl ester group in the PAE) of 3 to 12 carbon atoms, the imidization temperature is elevated in accordance with increasing number of carbon atoms of the alkyl ester groups of the PAE (High polymer, Vol. 50,

No. 12, pp.947-952 (1993)). Therefore, when the resin composition varnish containing the PAE is applied onto a substrate, and the substrate is prebaked for vaporizing the solvent, the imide fraction of the PAE is not increased, and a preferable positive type relief pattern can be obtained. If the number of carbon atoms in the alkyl ester group is less than 2, the imide fraction is increased by the prebaking, and a preferable relief pattern is hard to be obtained. If the number of carbon atoms exceeds 12, the hydrophobic property becomes too strong, and a preferable relief pattern is hard to be obtained.

When an organic solvent is used as developer, the development can be achieved even if the imide fraction is increased during the prebaking, because the organic solvent has a high solubility for the polyimide precursor. On the contrary, an alkaline aqueous solution has a low solubility for the polyimide precursor, and a small increase in the imide fraction significantly influences the pattern formation, when an alkaline aqueous solution is used as the developing solution like in the present invention.

When the hydrophobic group is an alkyl group of 3 to 12 carbon atoms, an adequate balance between the hydrophobic alkyl groups and the hydrophilic carboxylic groups in the $R_1$ groups is achieved, and preferable relief patterns can be formed.

The average molecular weight (hereinafter, the weight average molecular weight, $\overline{M}w$, is indicated) of the PAE of the present invention is desirably in the range of 8,000 to 200,000, based on styrene-reduced values obtained by GPC (Gel Permeation Chromatography). If $\overline{M}w$ is less than 8,000, the mechanical strength of the polyimide is insufficient and improper for practical use, and if $\overline{M}w$ exceeds 200,000, the developing time becomes too long, and a preferable positive type relief pattern can hardly be obtained.

The preparation of the PAEs of the present invention is not restricted to any special method. When the $R_2$ in the general formula (I) is an alkyl group of 3 to 12 carbon atoms, generally, a tetracarboxylic acid ester is synthesized from a tetracarboxylic acid dianhydride and an alcohol, the carboxylic acid is chlorinated by a chlorinating agent such as thionyl chloride, and the chloride is reacted with a diamine.

As the tetracarboxylic acid dianhydride, any tetracarboxylic acid dianhydride which is generally used for photosensitive polyimides can be used. However, in the present invention, 3,3',4,4'-benzophenone tetracarboxylic acid dianhydride, 3,3',4,4'-diphenylethertetracarboxylic acid dianhydride, or 3, 3, 4,4'-biphenyltetracarboxylic acid dianhydride are preferably used. The positive type photosensitive resin composition varnish based on the above tetracarboxylic acid dianhydrides is advantageous in adhesiveness to the unexposed substrate during the development by an alkaline aqueous solution. Especially, 3,3',4,4'-benzophenone tetracarboxylic acid dianhydride is particularly desirable, because it leads to preferable adhesiveness between the unexposed portion and the substrate during the development, and it is not corrosive.

As the alcohol to be reacted with the above tetracarboxylic acid dianhydride, an aliphatic alcohol of 3 to 12 carbon atoms can be used. For instance, propanol, butanol, pentanol, hexanol, heptanol, octanol, nonanol, decanol, undecanol, dodecanol, and so on can be used. The alcohols may be primary alcohols, secondary alcohols or tertiary alcohols, and the hydroxy groups of the above alcohols can be in an arbitrary position.

As the diamine having carboxyl group, 3,5-diaminobenzoic acid, 2,5-diaminobenzoic acid, 2,5-diaminoterephthalic acid, and the like can be used. Examples for diamines not comprising carboxyl groups are p-phenylenediamine, p,p'-diaminodiphenylether, p'-diamino-terphenyl, bis[4-(3-aminophenoxy)-phenyl]sulfone, 2,4-diaminotoluene, m,m'-diaminobenzophenone, m-phenylenediamine, 2,2'-bis[4-(p-aminophenoxy)-phenyl]propane, bis[4-(p-aminophenoxy)-phenyl]sulfone, 3,3'-diaminobenzophenone, 2,2'-bis(4-(3-aminophenoxy)-phenyl]hexafluorpropane, 1,3-bis(3-aminophenoxy)benzene, 2,2-bis[(3-aminophenoxy)phenyl]propane, and the like.

When a polyimide film is formed with the present PAE using a silicon substrate, a self-adhesion type diamine, which has preferable adhesiveness with the silicon substrate, can be mixed with the above diamine. As the self-adhesion type diamine, 1,3-bis(3-aminopropyl)tetramethyldisiloxane, 1,3-bis(3-aminophenyl)tetramethyldisiloxane, 1,3-bis(3-aminopropyl)tetraphenyldisiloxane, 1,3-bis(3-aminophenyl)tetraphenyldisiloxane, and the like can be used. Decrease in mechanical strength of the polyimide film can be prevented by adding a self-adhesion type diamine in an amount which is less than 15 mol % of the diamine component in the polyimide precursor.

As the chlorinating agent, phosphorus trichloride, phosphorus pentachloride, and the like can be used in addition to thionyl chloride.

[2] photosensitive agent

As a photosensitive agent in the positive type photosensitive resin composition, an o-quinonediazide sulfonyl amide compound expressed by the following general formula (II):

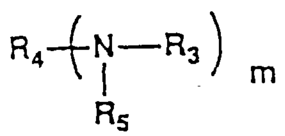

(II),

wherein are:

$R_3$ an o-quinonediazidesulfonic group,
$R_4$ an organic group of 2 to 30 carbon atoms,
$R_5$ an alkyl group or hydrogen, and
m 1 to 6,

and/or an o-quinonediazidesulfonyl amide sulfonic ester compound expressed by the following general formula (III):

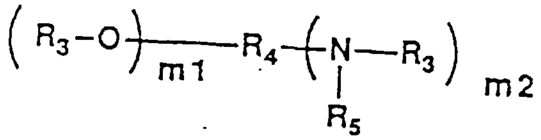

(III),

wherein are:

$R_3$ an o-quinonediazidesulfonic group,
$R_4$ an organic group of 2 to 30 carbon atoms,
$R_5$ an alkyl group or hydrogen,
m 1 to 5, and
$m_2$ 1 to 6,

or teir mixtures can be used.

When the $R_5$ in the general formula (II) or (III) is an alkyl group, the number of carbon atoms is desirably restricted to utmost 10, and particularly, restricted to utmost 8, in order to prevent dissolution of the unexposed portions during the development.

The above o-quinonediazidesulfonyl amide compound and o-quinonediazidesulfonyl amide sulfonic ester compound generate carboxyl groups by light irradiation to realize the dissolution enhancing effect of PAE at the exposed portions, and react as a light dissolution controlling agent of PAE. The sulfonyl amide portion enhances the solubility into the alkaline aqueous solution, and particularly, improves the dissolution enhancing effect at the exposed portion. The dissolution rate of the exposed portions and the unexposed portion can be controlled by altering the kind of the substituted groups, the number of the substituted groups, and the ratio of the sulfonyl amide and sulfonic ester contained.

o-Quinonediazidesulfonyl amide compounds usuable in the present invention are, for instance, 4,4'-bis(1,2-naphthoquinone-2-diazide-5-sulfonylamino)diaminodiphenylether, 4-(1,2-naphthoquinone-2-diazide-5-sulfonylamino)-1-(1,2-naphthoquinone-2-diazide-5-sulfonyloxy)benzene, N-methyl-1,2-bis(1,2-naphthoquinone-2-diazide-5-sulfonylamino)ethane, 2-(1,2-naphthoquinone-2-diazide-5-sulfonylamino)-1-(1,2- naphthoquinone-2-diazide-5-sulfonyloxy)ethane, 2,2-bis(4-(p-(1,2-naphthoquinone-2-diazide-5-sulfonylamino)phenoxy)phenyl)propane, 2,2-bis(4-(p-(1,2-naphthoquinone-2-diazide-5-sulfonylamino)phenoxy)phenyl)hexafluoropropane, m-xylylenedi(1,2-naphthoquinone-2-diazide-5-sulfonylamine), p-xylylenedi(1,2-naphthoquinone-2-diazide-5-sulfonylamine), and the like.

o-Quinonediazidesulfonyl amide sulfonic ester compounds usable in the present invention are, for instance, 2-(1,2-naphthoquinone-2-diazide-5-sulfonylamino)-1-(1,2- naphthoquinone-2-diazide-5-sulfonyloxy)benzene, 3-(1,2-naphthoquinone-2-diazide-5-sulfonylamino)-1-(1,2- naphthoquinone-2-diazide-5-sulfonyloxy)benzene, 4-(1,2-naphthoquinone-2-diazide-5-sulfonylamino)-1-(1,2- naphthoquinone-2-diazide-5-sulfonyloxy)benzene, 4-(1,2-naphthoquinone-2-diazide-5-sulfonylamino)-1-(1,2-naphthoquinone-2-diazide-5-sulfonyloxy)butane, 2,4-(1,2-naphthoquinone-2-diazide-5-sulfonylamino)-1-(1,2-naphthoquinone-2-diazide-5-sulfonyloxy)butane, 5-(1,2-naphthoquinone-2-diazide-5-sulfonylamino)-1-(1,2-naphthoquinone-2-diazide-5-sulfonyloxy)pentane, 5-(1,2-naphthoquinone-2-diazide-5-sulfonylamino)-2-(1,2-naphthoquinone-2-diazide-5-sulfonyloxy)pentane, N-methyl-5-(1,2-naphthoquinone-2-diazide-5-sulfonylamino)-2-(1,2-naphthoquinone-2-diazide-5-sulfonyloxy)pentane, 2-(1,2-naphthoquinone-2-diazide-5-sulfonylamino)-1-(1,2-naphthoquinone-2-diazide-5-sulfonyloxy)cyclohexane, 3-(1,2-naphthoquinone-2-diazide-5-sulfonylamino)-1-(1,2-naphthoquinone-2-diazide-5-sulfonyloxy)cyclohexane, 4-(1,2-naphthoquinone-2-diazide-5-sulfonylamino)-1-(1,2-naphthoquinone-2-diazide-5-sulfonyloxy)cyclohexane, and the like.

The o-quinonediazidesulfonyl amide compound expressed by the following general formula (II) and the o-quinonediazidesulfonyl amide sulfonic ester compound expressed by the following general formula (III) are generally prepared by a condensation reaction of o-quinonediazidesulfonyl chloride with a diamine compound or an amine compound containing a hydroxyl group. Examples for the o-quinonediazidesulfonyl chloride, are, for instance, 1,2-naphthoquinone-2-diazide-4-sulfonic acid chloride, 1,2-naphthoquinone-2-diazide-5-sulfonic acid chloride, and the like.

The compounds which react with the above o-quinonediazidesulfonyl chloride to obtain the o-quinonediazidesulfonylamidecompound are, for instance, aniline, benzylamine, 1-naphthylamine, 2-naphthylamine, hexylamine, octylamine, dodecylamine, octadecylamine, 1,3-diaminobenzene, 1,4-diaminobenzene, 4,4-diaminobiphenyl, 4,4-diaminodiphenylmethane, 4,4-diaminodiphenylether, 4,4-diaminodiphenylketone, 4,4-diaminodiphenylsulfone, 2,2-bis(4-aminophenyl)propane, 2,2-bis(4-aminophenyl)-1,1,1,3,3,3-hexafluoropropane, bis(4-aminopropyl)tetramethyldisiloxane, 1,2,4-triaminobenzene, 1,3,5-triaminobenzene, 3,4,4-triaminodiphenylether, 3,3',4,4'-diaminodiphenyl, 3,3',4,4'-tetradiaminodiphenylether, 1,2-diaminoethylene, N,N'-dimethyl-1,2-diaminoethylene, 1,3-diamonopropane, 1,4-diamonobutane, N,N'-dimethyl-1,4-diaminobutane, 1,6-diaminohexane, 1,8-diaminooctane, 1,10-diaminodecane, 1,12-diaminododecane, 2-butyl-2-ethyl-1,5-pentanediamine, 4-aminomethyl-1,8-diaminooctane, diethylenetriamine, bis(hexamethylene) triamine, triethylenetetramine, tetraethylenepentamine, and the like.

Compounds which are usable for obtaining the o-quinonediazidesulfonyl amide sulfonic ester compound are, for instance, 2-aminophenol, 3-aminophenol, 4-aminophenol, 2,3-diaminophenol, 2,4-diaminophenol, 4-aminoresorcinol, 4,4'-diamino-3,3'-dihydroxybiphenyl, 3,3'-diamino-4,4'-dihydroxybiphenyl, 2-aminoethanol, N-methyl-2-aminoethanol, 3-aminopropanol, 2-aminobutanol, 2-amino-3-methylbutanol, 4-aminobutanol, 5-aminopentanol, 6-aminohexanol, 4-aminocyclohexanol, 2-aminoheptanol, 6-amino-2-methyl-2-heptanol, 8-aminooctanol, 10-aminodecanol, 12-aminododecanol, 1-amino-2,3-propanediol, 2-amino-1,3-propanediol, 2-amino-2-ethyl-1,3-propanediol, bis-homotris(hydroxymethyl)aminomethane, and the like.

[3} Positive type photosensitive resin composition

The positive type photosensitive resin composition of the present invention includes the polyamic acid ester, the o-quinonediazidesulfonyl amide compound, and/or the o-quinonediazidesulfonyl amide sulfonic ester compound explained above. The mixing ratio of the o-quinonediazidesulfonyl amide compound and/or the o-quinonediazidesulfonyl amide sulfonic ester compound to the polyamic acid ester is preferably in the range of 5 to 40 % by weight. If exceeding 40 % by weight, the mechanical strength of the obtained polyimide film is insufficient, and if less than 5 % by weight, the sensitivity to the exposure is insufficient, and the radiation dose must be increased.

The positive type photosensitive resin composition of the present invention can be developed by an alkaline aqueous solution. Therefore, the resin composition is not harmful to the human body and the environment since no organic solvents are used for the development. As the alkaline aqueous developing solution, hydroxy quaternary ammonium aqueous solution such as tetraammonium hydroxide, tetraethylammonium hydroxide, and the like, and amine group containing aqueous solutions such as ethanolamine, propylamine, and the like, are usable. Generally, a 2,38 % aqueous tetraammonium hydroxide solution is used mostly.

[4] positive type photosensitive resin composition varnish

In order to form polyimide films with the positive type photosensitive resin composition of the present invention, the positive type photosensitive resin composition is dissolved in an organic solvent, preferably in a polar solvent, to form a varnish, and the varnish is used for forming the polyimide film. The mixing ratio of the positive type photosensitive resin

composition and the organic solvent is decided in consideration of the film thickness required for the film and the application performance. Generally, it is desirable to mix the positive type photosensitive resin composition and the organic solvent so that the total concentration (called NV, hereinafter) of the polyamic acid ester, o-quinonediazidesulfonyl amide compound and/or the o-quinonediazidesulfonyl amide sulfonic ester compound contained in the positive type photosensitive resin composition is to be in the range of 5 ~ 45 % by weight in the varnish. When the NV exceeds 45 % by weight, the viscosity of the varnish becomes too high, and problems such as difficult control of the film thickness, and residual voids are generated. When the NV is less than 5 % by weight, it is difficult to obtain polyimide films having an uniform film thickness of more than 3.0 μm.

The positive type photosensitive resin composition varnish of the present invention can be prepared by mixing the PAE, the o-quinonediazidesulfonyl amide compound, and/or the o-quinonediazidesulfonyl amide sulfonic ester compound in a polar organic solvent with agitation.

As polar solvents, N-methyl-2-pyrrolidone, N,N'-dimethylacet amide, dimethylformamide, dimethylsulfoxide, acetonitrile, diglyme, γ-butyrolactone, phenol, toluene, dioxane, tetrahydrofuran, sulfolane, hexamethylphosphoramide, and the like are usable.

[5] Polyimide films

The polyimide films of the present invention can be formed with the above positive type photosensitive resin composition varnish. First, the positive type photosensitive resin composition varnish of the present invention is applied onto a solid body, generally a substrate such as a glass plate or a silicon wafer, by a method such as spin coating, and others. The film thickness is desirably about 0.5 to 20 μm.

After the application, a prebaked film is formed by prebaking the applied film at a temperature in the range of 40 to 90 °C for 1 to 6 minutes in order to evaporate the solvent to some extent. Subsequently, the film is irradiated with ultraviolet rays through a photomask having a desired pattern. By using the positive type photosensitive resin composition (varnish), the exposure can be completed with a small dose, practically, such as 100 to 400 mJ/cm$^2$.

After the exposure with ultraviolet rays, the film is immersed into an alkaline aqueous solution, as described previously, to perform the etching of the exposed portions. When the positive type photosensitive resin composition (varnish) is used, the edges of the pattern are cut clearly, because the composition is superior in the dissolution prevention effect at the unexposed portions and the dissolution enhancing effect at the exposed portions, and polyimide films having the desired pattern can be obtained. For instance, when a photomask having a pattern of 100 μm is used, the obtained pattern of polyimide film can be within the range of 97 to 103 μm.

After the etching, the film is washed with water, and the polyimide film can be obtained by thermal imide formation. The temperature for the thermal imide formation after the development is desirably in the range of 200 to 450 °C, the range of 300 to 450 °C being particularly preferably. In accordance with the present invention, the o-quinonediazidesulfonyl amide compound, and/or the o-quinonediazidesulfonyl amide sulfonic ester compound in the unexposed portions is evaporated partly, and carboxyl groups in the polyamic acid ester are decomposed to generate carbon dioxide during the thermal imide formation. Therefore, polyimide films superior in their insulating properties and heat resistance can be obtained.

As explained above, the positive type photosensitive resin composition (varnish) of the present invention can be developed with an alkaline aqueous solution, and polyimide films having fine and reliable positive type relief patterns can be formed.

[6] Electronic apparatus

The polyimide films formed from the positive type photosensitive resin composition (varnish) of the present invention can be utilized as insulating films of various electronic apparatus such as inter-layer insulating films, passivation films for semiconductor devices, insulating films for multilayer printing substrates, and the like. Electronic apparatus, are, for example, microcomputers, memories, gate arrays, logic circuits, and the like. Examples for the mounting conditions are PGA (pin grid array), QFP (quad flat package), SOJ (small outline-j-bended package), SOP (small outline package, TSOP (thin small outline package), TQFP (thin quad flat package), ZIP (zigzag in-line package), BGA (ball grid array), CSP (chip size package), COB (chip on board), and the like.

Brief Description of the Drawings

These and other objects, features and advantages of the present invention will be understood more clearly from the following detailed description with reference to the accompanying drawings, wherein,

Figs. 1A to 1D are a set of schematic illustrations of the manufacturing process of a resin sealed semiconductor device using the positive type photosensitive resin composition of the present invention.

A set of schematic illustrations of the manufacturing process of a resin sealed semiconductor device, which is an example of the electronic apparatus of the present invention, is indicated in Figs. 1A to 1D:

(1A) A stratified substrate of an LSI chip 2 on a tab 3, bonding pads 1a, 1b on the LSI chip 2, is prepared.

(1B) The positive type photosensitive resin composition varnish 4 is applied onto the surface of the LSI chip 2 so as to coat the bonding pads 1a und 1b.

(1C) After prebaking, the applied varnish is exposed to light using a photomask having through-holes at locations corresponding to the bonding pads 1a and 1b. Then, etching with an alkaline aqueous solution and thermal treatment are performed. Through-holes 50 are formed in the fabricated polyimide film 5 at the locations corresponding to the bonding pads 1a and 1b.

(1D) Each of the bonding pads 1a and 1b is connected with the lead frame 7 by a bonding wire 6 through the through-hole 50. Then the resin sealed semiconductor device can be formed by molding the whole body with a sealing agent 8.

Description of Preferred Embodiments

Hereinafter, embodiments of the present invention are explained in detail, but the scope of the present invention is not restricted by these embodiments.

Abbreviations of the compounds used in the embodiments and the comparative examples are as follows:

3,3',4,4'-Benzophenone tetracarboxylic acid dianhydride → BTDA
3,3',4,4'-Diphenylether tetracarboxylic acid dianhydride → ODPA
3,3',4,4'-Biphenyl tetracarboxylic acid dianhydride → BPDA
Methyl alcohol → MeOH
Propyl alcohol → PrOH
Butyl alcohol → BuOH
Hexyl alcohol → HeOH
Octyl alcohol → OcOH
Dodecyl alcohol → DoOH
3,5-diamino-benzoic acid → DABA
p,p'-diaminodiphenylether → DDE
2,2'-bis((4,4-aminophenoxy)phenyl)propane → DAPP
1,3-bis(3-aminopropyl)tetramethyldisiloxane → BAT
n-methyl-2-pyrrolidone → NMP
4,4'-bis(1,2-naphthoquinone-2-diazide-5-sulfonyl amino)diaminodiphenylether → DDE-Q
4-(1,2-naphthoquinone-2-diazide-5-sulfonylamino)-1-(1,2-naphthoquinone-2-diazide-5-sulfonyloxy)benzene → AMP-Q
N-methyl-1,2-bis(1,2-naphthoquinone-2-diazide-5-sulfonylamino)ethane → MEDA-Q
2-(1,2-naphthoquinone-2-diazide-5-sulfonylamino)-1-(1,2-naphthoquinone-2-diazide-5-sulfonyloxy)ethane → AME-Q
An ester compound of 1,2-naphthoquinone-2-diazide-5-sulfonic acid chloride and 2,3,4,4'-tetrahydroxybenzophenone → 4NT-300 (made by Toyo Gosei Co.)

(Embodiment 1)

BTDA (12.35 g, (0.03833 mol) was mixed with 1-BuOH (12.0 g); the mixture was refluxed for 1 hour, and butyl ester of 3,3',4,4'-benzophenone tetracarboxylic acid was obtained by removing excess 1-BuOH under reduced pressure. The ester was mixded with purified thionyl chloride (12.0 g, 0.09 mol); the mixture was refluxed for 1 hour, and the butyl ester dichloride of 3,3',4,4'-benzophenone tetracarboxylic acid 27.2 g was obtained by removing excess thionyl chloride. Then, NMP (27.2 g) was added to the butyl ester dichloride for dissolving, and an acid chloride solution (50 %) was obtained.

On the other hand, 3,5-DABA (3.50 g, 0.023 mol), DDE (2.68 g, 0.0134 mol), BAT (0.48 g, 0.0019 mol), and NMP (45 g) were mixed together (DABA/DDE/BAT = 60/35/5), and the obtained solution was designated as the diamine solution. The acid chloride solution was added to the diamine solution, which was cooled below 10 °C, slowly dropwise for 1 hour, and then agitated for 1 hour. Subsequently, the mixture was poured into water (3 l). The obtained precipitate was washed repeatedly, filtered and dried in vacuo at 40 °C for 72 hours to obtain the object PAE. The obtained PAE had a

molecular weight of 72,000.

A photosensitive agent was prepared by the following steps: Triethylamine (6.7 ml, 0.12 mol) was added to a dioxane solution (50 ml) containing 1,2-naphthoquinone-2-diazide-5-sulfonyl chloride (10.8 g, 0.04 mol) and DDE (4.00 g, 0.02 mol) dropwise, and stirred at room temperature for 3 hours. The reaction mixture was filtered, and the filtrate was added dropwise to 2 liters of 1N aqueous hydrochloric acid solution to obtain a precipitate. The precipitate was filtered off, and DDE-Q (12.5 g) was obtained by drying the precipitate in vacuo at 40 °C for 48 hours.

The PAE (10 g) was dissolved by adding DDE-Q (2.5 g, 25 wt.%) and NMP (23.2 g, MV 35 %), and the positive type photosensitive resin composition varnish was obtained by filtering the solution with pressure through a filter of a pore size of 1.0 μm. The raw materials and composition used are listed in Table 1.

The obtained positive type photosensitive resin composition varnish was spin-coated at 2500 rpm for 30 seconds onto the non-treated surface of a silicon wafer. Subsequently, the wafer was prebaked on a hot-plate of 80 °C for 3 minutes, and a coated film of 7.0 μm thickness was obtained. The coated film was exposed to light at a dose of 300 mJ/$cm^2$ with a maskaligner (made by Dainippon Screen Co., MAP-1300 type, light source made by Ushio Denki Co. UVD-405PD type super high pressure mercury lamp) through a photomask having fine patterns.

After the exposure, the film was developed by immersing into an alkaline developing solution (2.38 % aqueous solution of tetramethylammonium hydroxide) at 23 °C for 90 seconds. By washing the developed film with pure water for 30 seconds, a relief pattern of 6.2 μm thickness, the unexposed portions of which were not corroded, was obtained. The film was thermally treated for imide formation by 100 °C /30 minutes + 160 °C /30 minutes + 250 °C /30 minutes + 350 °C /30 minutes with a hot blowing dryer, and a polyimide film (3.5 μm thick) having a preferable positive type relief pattern was obtained.

(Embodiment 2)

In accordance with the same method as in the embodiment 1 except using the composition indicated in Table 1, a PAE of Mw 51,000 was synthesized, and the positive type photosensitive resin composition varnish was prepared. The photosensitive agent, i.e. AMP-Q, was synthesized by the following process.

A pyridine solution (200 ml) containing 4-aminophenol (6.35 g, 0.058 mol) was added dropwise to a pyridine solution (100 ml) containing 1.2-naphthoquinone-2-diazide-5-sulfonyl chloride (21.9 g, 0.081 mol) with keeping the temperature of the reactant below 5 °C, and agitated for 30 minutes. Subsequently, triethylamine (6.7 ml, 0.12 mol) was added, and it was agitated at room temperature for 3 hours. Then, a pyridine solution (100 ml) containing 1.2-naphthoquinone-2-diazide-5-sulfonyl chloride (15.6 g, 0.058 mol) and triethylamine (15 ml) was added dropwise with keeping the temperature of the reactants below 15 °C, and agitated for 3 hours. After filtration, a precipitate was obtained by adding the filtrate to 1N aqueous hydrochloric acid solution (5 liters). The precipitate was filtered, and AMP-Q (24.3 g) was obtained by drying the precipitate in vacuo at 40 °C for 48 hours.

In accordance with the same method as in embodiment 1, a polyimide film was formed with the prepared positive type photosensitive resin composition varnish. As the result, a polyimide film (3.8 μm thick) having a preferable positive type relief pattern, the unexposed portions of which were not corroded, was obtained.

(Embodiment 3)

In accordance with the same method as in embodiment 1 except using the composition indicated in Table 1, a PAE of Mw 22,000 was synthesized, and a positive type photosensitive resin composition varnish was prepared. The photosensitive agent, i.e. MEDA-Q, was synthesized by following process.

A dioxane solution (50 ml) containing N-methylenediamine (0.644 g, 0.0086 mol) was added dropwise to a dioxane solution (50 ml) containing 1.2-naphthoquinone-2-diazide-5-sulfonyl chloride (5.52 g, 0.02 mol) with keeping the temperature of the reactants below -20 °C, and agitated for 30 minutes. After returning the temperature of the reactants to room temperature, triethylamine (1.3 ml, 0.011 mol) was added, and it was agitated at room temperature for 1 hour. After filtration, a precipitate was obtained by adding the filtrate to 1N aqueous hydrochloric acid solution (1 l). The precipitate was filtered off, and MEDA-Q 2.10 g was obtained by drying the precipitate in vacuo at 40 °C for 48 hours.

In accordance with the same method as in the embodiment 1, a polyimide film was formed with the prepared positive type photosensitive resin composition varnish. As the result, a polyimide film (3.6 μm thick) having a preferable positive type relief pattern, the unexposed portions of which were not corroded, was obtained.

(Embodiment 4)

In accordance with the same method as in embodiment 1 except using the composition indicated in Table 1, a PAE of Mw 20,000 was synthesized, and a positive type photosensitive resin composition varnish was prepared. The photosensitive agent, i.e. AME-Q, was synthesized by following process.

A pyridine solution (5 ml) containing N-aminoethanol (0.648 g, 0.0106 mol) was added dropwise to a pyridine solution (15 ml) containing 1.2-naphthoquinone-2-diazide-5-sulfonyl chloride (6.62 g, 0.024 mol) with keeping the temperature of the reactants below -25 °C, and agitated for 30 minutes. After returning the temperature of the reactants to room temperature, triethylamine (6.7 ml, 0.12 mol) was added, and it was agitated for 3 hours. After filtration, a precipitate was obtained by adding the filtrate to 1N aqueous hydrochloric acid solution (1 l). The precipitate was filtered off, and AME-Q (2.55 g) was obtained by drying the precipitate in vacuo at 40 °C for 48 hours.

In accordance with the same method as in embodiment 1, a polyimide film was formed with the prepared positive type photosensitive resin composition varnish. As the result, a polyimide film (3.6 μm thick) having a preferable positive type relief pattern, the unexposed portions of which were not corroded, was obtained.

(Embodiment 5)

In accordance with the same method as in embodiment 1 except using the composition indicated in Table 1, a PAE of $\overline{M}w$ 19,000 and DDE-Q was synthesized, and a positive type photosensitive resin composition varnish was prepared.

In accordance with the same method as in embodiment 1, a polyimide film was formed with the prepared positive type photosensitive resin composition varnish. As the result, a polyimide film (3.7 μm thick) having a preferable positive type relief pattern, the unexposed portions of which were not corroded, was obtained.

(Embodiment 6)

In accordance with the same method as in embodiment 1 except using the composition indicated in Table 1, a PAE of $\overline{M}w$ 20,000 and DDE-Q was synthesized, and a positive type photosensitive resin composition varnish was prepared.

In accordance with the same method as in embodiment 1, a polyimide film was formed with the prepared positive type photosensitive resin composition varnish. As the result, a polyimide film (3.5 μm thick) having a preferable positive type relief pattern, the unexposed portions of which were not corroded, was obtained.

(Embodiment 7)

In accordance with the same method as in embodiment 1 except using the composition indicated in Table 1, a PAE of Mw 20,000 and DDE-Q was synthesized, and a positive type photosensitive resin composition varnish was prepared.

In accordance with the same method as in embodiment 1, a polyimide film was formed with the prepared positive type photosensitive resin composition varnish. As the result, a polyimide film (3.5 μm thick) having a preferable positive type relief pattern, the unexposed portions of which were not corroded, was obtained.

(Embodiment 8)

In accordance with the same method as in embodiment 1 except using the composition indicated in Table 1 and DAPP instead of DDE, a PAE of $\overline{M}w$ 46,000 was synthesized, and with the same method as in embodiment 2, AMP-Q was synthesized. Then, a positive type photosensitive resin composition varnish was prepared.

In accordance with the same method as in embodiment 1, a polyimide film was formed with the prepared positive type photosensitive resin composition varnish. As the result, a polyimide film (3.5 μm thick) having a preferable positive type relief pattern, the unexposed portions of which were not corroded, was obtained.

(Embodiment 9)

In accordance with the same method as in embodiment 1 except using the composition indicated in Table 1, a PAE of $\overline{M}w$ 155,000 was synthesized, and with the same method as in embodiment 3, MEDA-Q was synthesized. Then, a positive type photosensitive resin composition varnish was prepared.

In accordance with the same method as in embodiment 1, a polyimide film was formed with the prepared positive type photosensitive resin composition varnish. As the result, a polyimide film (3.6 μm thick) having a preferable positive type relief pattern, the unexposed portions of which were not corroded, was obtained.

(Embodiment 10)

In accordance with the same method as in embodiment 1 except using the composition indicated in Table 1, a PAE of $\overline{M}w$ 21,000 was synthesized, and with the same method as in embodiment 3, MEDA-Q was synthesized. Then, a positive type photosensitive resin composition varnish was prepared.

In accordance with the same method as in embodiment 1, a polyimide film was formed with the prepared positive type photosensitive resin composition varnish. As the result, a polyimide film (3.5 μm thick) having a preferable positive type relief pattern, the unexposed portions of which were not corroded, was obtained.

(Embodiment 11)

In accordance with the same method as in embodiment 1 except using the composition indicated in Table 1, a PAE of $\overline{M}w$ 22,000 was synthesized, and with the same method as in embodiment 4, AME-Q was synthesized. Then, a positive type photosensitive resin composition varnish was prepared.

In accordance with the same method as in embodiment 1, a polyimide film was formed with the prepared positive type photosensitive resin composition varnish. As the result, a polyimide film (3.6 μm thick) having a preferable positive type relief pattern, the unexposed portions of which were not corroded, was obtained.

(Embodiment 12)

In accordance with the same method as in embodiment 1 except using the composition indicated in Table 1, a PAE of $\overline{M}w$ 19,000 was synthesized, and with the same method as in embodiment 4, AME-Q was synthesized. Then, a positive type photosensitive resin composition varnish was prepared.

In accordance with the same method as in embodiment 1, a polyimide film was formed with the prepared positive type photosensitive resin composition varnish. As the result, a polyimide film (3.6 μm thick) having a preferable positive type relief pattern, the unexposed portions of which were not corroded, was obtained.

(Comparative example 1)

In accordance with the same method as in embodiment 1 except using the PAE used in embodiment 1 and 4NT-300, which was a sulfonic ester of o-quinonediazide, a positive type photosensitive resin composition varnish was prepared and a polyimide film was formed. The necessary exposure dose in this case was 500 $mJ/cm^2$.

The unexposed portions of the obtained polimide film (3.4 μm thick) were corroded, and the positive type relief pattern was not preferable.

(Comparative example 2)

In accordance with the same method as in embodiment 1 except using the composition indicated in Table 1 (alcohol: MeOH), a PAE of $\overline{M}w$ 23,000 and DDE-Q were synthesized. Then, a positive type photosensitive resin composition varnish was prepared.

In accordance with the same method as in embodiment 1, a polyimide film was formed with the prepared positive type photosensitive resin composition varnish. As the result, the unexposed portions of the obtained polyimide film (3.3 μm thick) were corroded, and the positive type relief pattern was not preferable.

(Comparative example 3)

In accordance with the same method as in embodiment 1 except using the composition indicated in Table 1 (DADB: 40 %), a PAE of $\overline{M}w$ 23,000 was synthesized, and with the same method as in embodiment 4, AME-Q was synthesized. Then, a positive type photosensitive resin composition varnish was prepared.

In accordance with the same method as in embodiment 1, a polyimide film was formed with the prepared positive type photosensitive resin composition varnish. The necessary developing time was as long as 6 to 7 minutes, and the positive type relief pattern of the obtained polyimide film (3.3 μm thick) was not preferable.

(Comparative example 4)

In accordance with the same method as in embodiment 1 except using the composition indicated in Table 1 (DADB: 95 %), a PAE of $\overline{M}w$ 18,000 and DDE-Q were synthesized, and a positive type photosensitive resin composition varnish was prepared.

In accordance with the same method as in embodiment 1, a polyimide film was formed with the prepared positive type photosensitive resin composition varnish. The necessary developing time was as short as a few seconds, and the positive type relief pattern of the obtained polyimide film (3.3 μm thick) was not preferable.

(Reference example 1)

In accordance with the same method as in embodiment 1 except adding aniline (0.32 g), i.e., an end capping agent, to butylester chloride of 3,3',4,4'-benzophenonetetracarboxylic acid (27.2 g), the PAE was synthesized. The obtained PAE had an $\overline{M}w$ of 7,000. Further, in accordance with the embodiment 1, DDE-Q was synthesized, and a positive type photosensitive resin composition varnish was prepared with the PAE and the DDE-Q.

In accordance with the same method as in embodiment 1, a polyimide film (3.0 μm thick) was formed with the prepared positive type photosensitive resin composition varnish. However, as the $\overline{M}w$ of the used PAE was as small as 7,000, the obtained polyimide film was not durable in practical use.

(Reference example 2)

In accordance with the same method as in embodiment 1 except using NMP, the water content of which was controlled at utmost 10 ppm, by adding the acid chloride solution dropwise to the diamine solution, which was maintained at below -18 °C, for 3 hours, the PAE was synthesized. The obtained PAE had an $\overline{M}w$ of 235,000. Further, in accordance with the embodiment 1, DDE-Q was synthesized, and a positive type photosensitive resin composition varnish was prepared with the PAE and the DDE-Q.

In accordance with the same method as in embodiment 1, a polyimide film (3.5 μm thick) was formed with the prepared positive type photosensitive resin composition varnish. However, as the $\overline{M}w$ of the used PAE was excessively large, the developing time was as long as 3.5 minutes, and the obtained positive type relief pattern was not preferable.

Table 1

| | Acid dianhydride | Alcohol | Mixed ratio of (DADB/DDE/BAT) | Photosensitive agent (wt.%) |
|---|---|---|---|---|
| Embodiment 1 | BTDA | 1-BuOH | 60/35/5 | DDE-Q (25) |
| Embodiment 2 | BTDA | 1-BuOH | 60/30/10 | AMP-Q (30) |
| Embodiment 3 | BTDA | 1-PrOH | 70/25/5 | MEDA-Q (30) |
| Embodiment 4 | BTDA | 1-PrOH | 70/18/12 | AME-Q (25) |
| Embodiment 5 | BTDA | 1-HeOH | 80/15/5 | DDE-Q (30) |
| Embodiment 6 | BTDA | 1-DoOH | 85/10/5 | DDE-Q (25) |
| Embodiment 7 | BTDA | 1-PrOH | 85/10/5 | DDE-Q (25) |
| Embodiment 8 | ODPA | 1-BuOH | 70/25*/5 | AMP-Q (40) |
| Embodiment 9 | ODPA | 1-PrOH | 55/35/10 | MEDA-Q (20) |
| Embodiment 10 | ODPA | 1-HeOH | 75/20/5 | MEDA-Q (30) |
| Embodiment 11 | ODPA | 1-OcOH | 80/15/5 | AME-Q (10) |
| Embodiment 12 | BPDA | 1-BuOH | 75/20/5 | AME-Q (35) |
| Comp. ex.1 ** | BTDA | 1-BuOH | 60/35/5 | 4NT-300(35) |
| Comp. ex. 2 | BTDA | MeOH | 60/35/5 | DDE-Q (30) |
| Comp. ex. 3 | ODDA | 1-HeOH | 40/55/5 | AME-Q (35) |
| Comp. ex. 4 | BTDA | 1-BuOH | 95/0/5 | DDE-Q (25) |

*: DAPP,
**: Comparative example

(Embodiment 13)

A resin sealed semiconductor device was manufactured using the positive type photosensitive resin composition varnish obtained by the embodiment 1.

A set of schematic illustrations of the manufacturing process is indicated in Figs. 1A to 1D.

(1A) A stratified substrate of an LSI chip (2) (length: 5 mm X width: 5 mm) on a tab 3, bonding pads 1a,1b (length: 120 μm X width: 120 μm) on the LSI chip 2, was prepared.

(1B) The positive type photosensitive resin composition varnish 4 was applied onto the surface of the LSI chip 2 by a spin-coater at 2600 rpm for 30 seconds.

(1C) After prebaking on a hot plate at 80 °C for 3 minutes, the applied varnish was exposed to light at 300 mJ/cm$^2$ with a maskaligner (made by Dainippon Screen Co., MAP-1300 type, light source made by Ushio Denki Co. UVD-405PD type super high pressure mercury lamp) through a photomask having through-holes (length: 100 μm X width: 100 μm ) at locations corresponding to the bonding pads 1a, 1b. Then, the exposed varnish was developed by immersing into an alkaline aqueous solution (2.38 % aqueous solution of tetramethylammonium hydroxide) at 23 °C for 1.5 minutes. Then, the film was washed with pure water for 30 seconds, and a relief pattern (5.8 μm thick) having through holes (length: 99 μm X width: 99 μm), the unexposed portions of which were not corroded, was obtained. The film was thermally treated for imide formation by 100 °C/30 minutes + 160 °C/30 minutes + 250 °C/30 minutes + 350 °C/30 minutes with a hot blowing dryer, and a polyimide film (3.5 μm thick) having a preferable positive type relief pattern was obtained.

(1D) The bonding pads 1a, 1b were connected with the lead frame 7 by a bonding wire 6 (diameter: 25 μm) through the through-holes 50. Then the resin sealed semiconductor device was formed by molding the whole body with a sealing agent 8 (RM370, made by Hitachi Kasei Co.).

In accordance with the present invention, polyimide films having preferable positive type relief patterns, the unexposed portions of which are not corroded, can be obtained.

## Claims

1. Polyamic acid esters of the general formula I,

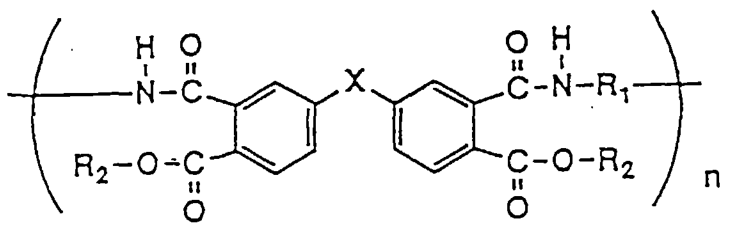

(I),

and/or of the general formula I',

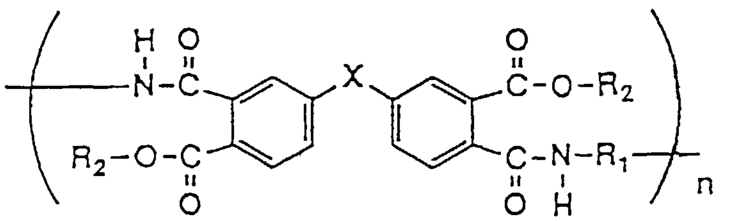

(I'),

and/or of the general formula I",

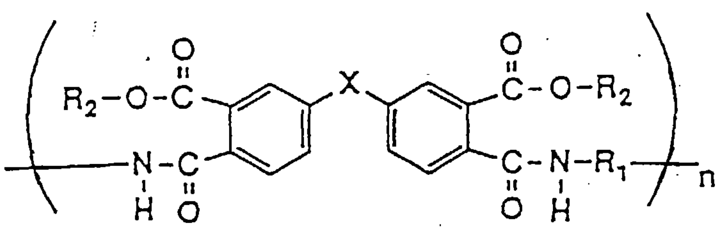

(I"),

in the above formulae I, I' and I" being

$R_1$ a divalent organic group,
$R_2$ a hydrophobic group,
X -O-, -CO- or a C-C single bond,
and
n an integer of at least 3,

with the proviso that more than 50 mol-% of the groups $R_1$ comprise one or more and preferably one or two carboxyl groups.

2. Polyamic acid esters of formulae I, I' and/or I" according to claim 1, wherein 55 to 85 mol-% of the groups $R_1$ contain one or more and preferably one or two carboxyl groups.

3. Polyamic acid esters of formulae I, I' and/or I" according to claim 1 or 2, wherein n is an integer of at least 6 and preferably of 6 to 1000, and more preferably an integer of 6 to 570.

4. Polyamic acid esters of formulae I, I' and/or I" according to one or more of claims 1 to 3,
wherein the divalent organic groups $R_1$ not comprising carboxyl groups are selected from aliphatic, cycloaliphatic and/or aromatic groups which may be fluorinated, preferably from o-, m- and p-phenylene, diphenylether groups, terphenyl groups, bis(4-phenoxyphenyl)-sulfone groups, tolylene groups, benzophenone groups, 2,2'-bis(4-phenoxyphenyl)propane groups, bis[4-(4-phenoxy)-phenyl]sulfone groups, 2,2'-bis(4-phenoxyphenyl)hexafluoropropane groups, 1,3-bis(phenoxy)benzene groups and 2,2-bis(phenoxyphenyl)propane groups, all possible linkage positions being included.

5. Polyamic acid esters of formulae I, I' and/or I" according to one or more of claims 1 to 4,
wherein the divalent organic groups $R_1$ containing one or more carboxyl groups are selected from o-, m- and p-phenylene, diphenylether groups, terphenyl groups, bis(4-phenoxyphenyl)-sulfone groups, tolylene groups, benzophenone groups, 2,2'-bis(4-phenoxyphenyl)propane groups, bis[4-(4-phenoxy)-phenyl]sulfone groups, 2,2'-bis(4-phenoxyphenyl)hexafluoropropane groups, 1,3-bis(phenoxy)benzene groups and 2,2-bis(phenoxyphenyl)propane groups, all possible linkage positions being included.

6. Polyamic acid esters of formulae I, I' and/or I" according to one or more of claims 1 to 5, wherein the hydrophobic groups $R_2$ are selected from aliphatic, cycloaliphatic and/or aromatic hydrocarbon groups which may be fluorinated, preferably from $C_{3-12}$-alkyl groups and fluorinated $C_{3-12}$-alkyl groups.

7. Polyamic acid esters according to one or more of claims 1 to 6, having a weight average molecular weight, $\overline{M}w$, of 8000 to 200 000.

8. Method for preparing the polyamic acid esters of formulae I, I' and/or I" according to claims 1 to 7,
characterized in that

- a tetracarboxylic acid dianhydride of the general formula IV,

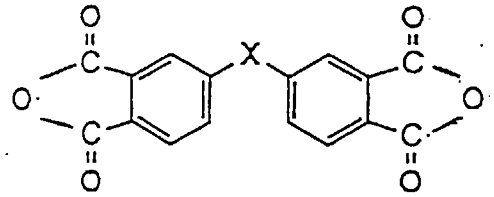

(IV) ,

wherein X is -O-, -CO- or a C-C single bond,
is allowed to react with an alcohol of the general formula V,

$$R_2\text{-OH} \quad (V),$$

wherein $R_2$ is defined as in claim 1 or 6,
to obtain a tetracarboxylic acid ester,
- the carboxylic acid groups of the tetracarboxylic acid ester are converted into carboxylic acid chloride groups

by a chlorinating agent, preferably thionyl chloride, and

- the obtained tetracarboxylic acid ester chloride is allowed to react with a diamine of the general formula VI,

$$H_2N\text{-}R_1\text{-}NH_2 \quad (VI),$$

wherein $R_1$ is defined as in claims 1, 4 or 5, to obtain the polyamic acid ester of formulae I, I' and/or I".

**9.** Method according to claim 8, characterized in that a mixture of at least one diamine of formula VI not comprising carboxyl groups and at least one diamine of formula VI comprising one or more and preferably two carboxyl groups is used, the proportion of carboxyl-free and carboxyl-containing diamines being such that in the final product of formulae I, I' and/or I" more than 50 mol-% and preferably 55 to 85 mol-% of the groups $R_1$ comprise one or more carboxyl groups and preferably one or two carboxyl groups.

**10.** Method according to claim 8 or 9, characterized in that the diamine of formula VI not comprising carboxyl groups is selected from p-phenylenediamine, p,p'-diaminodiphenylether, p'-diaminoterphenyl, bis[4-(3-aminophenoxy)-phenyl]sulfone, 2,4-diaminotoluene, m,m'-diaminobenzophenone, m-phenylenediamine, 2,2'-bis[4-(p-aminophenoxy)-phenyl]propane, bis[4-(p-aminophenoxy)-phenyl]sulfone, 3,3'-diaminobenzophenone, 2,2'-bis[4-(3-aminophenoxy)-phenyl]hexafluoropropane, 1,3-bis(3-aminophenoxy)benzene and 2,2-bis[(3-aminophenoxy)-phenyl]propane.

**11.** Method according to one or more of claims 8 to 10, characterized in that the diamine of formula VI comprising one or more hydroxyl groups is selected from 3,5-diaminobenzoic acid, 2,5-diaminobenzoic acid and 2,5-diaminoterephthalic acid.

**12.** Method according to one or more of claims 8 to 11, characterized in that the alcohol of formula V is selected from propanol, butanol, pentanol, hexanol, heptanol, octanol, nonanol, decanol, undecanol and dodecanol, where the alcohol may be primary, secondary or tertiary, and the hydroxy group may be in an arbitrary position.

**13.** Positive type photosensitive resin composition, which can be developed by an alkaline aqueous solution, comprising

(A) a polyamic acid ester of formula I, I' or I" according to any of claims 1 to 7,
(B) an o-quinonediazidesulfonyl amide compound of the general formula II,

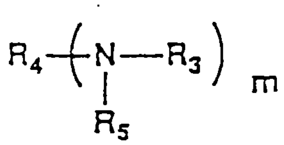

(II),

wherein are:

$R_3$ an o-quinonediazidesulfonic group,
$R_4$ an organic group of 2 to 30 carbon atoms,
$R_5$ an alkyl group or hydrogen,
and
m an integer of 1 to 6,
and/or

(C) an o-quinonediazidesulfonyl amide sulfonic ester compound of the general formula (III),

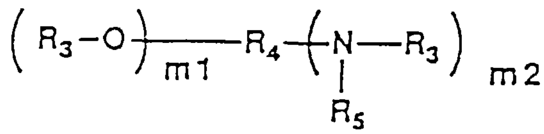

(III),

wherein are:

$R_3$ an o-quinonediazidesulfonic group,
$R_4$ an organic group of 2 to 30 carbon atoms,
$R_5$ an alkyl group or hydrogen,
$m_1$ an integer of 1 to 5,
and
$m_2$ an integer of 1 to 6.

**14.** Photosensitive resin composition according to claim 13, wherein the proportion of the o-quinonediazidesulfonyl amide compound (B) and/or the o-quinonediazidesulfonyl amide sulfonic ester compound (C), based on the polyamic acid ester (A), is in the range of 5 to 45 and preferably of 5 to 40 % by weight.

**15.** Positive type photosensitive resin composition varnish comprising the positive type photosensitive resin composition of claim 13 or 14 and an organic solvent, the total concentration of the polyamic acid ester (A), the o-quinonediazidesulfonyl amide compound (B) and/or the o-quinonediazidesulfonyl amide sulfonic ester compound (C) being in the range of 5 to 45 and preferably of 5 to 40 % by weight.

**16.** Polyimide films obtained with the positive type photosensitive resin composition varnish as claimed in claim 15.

**17.** Method for manufacturing polyimide films, comprising the steps of:

- applying a positive type photosensitive resin composition varnish as claimed in claim 15 onto a solid body,
- prebaking,
- exposing to light using a photomask having a desired pattern,
- etching with an alkaline aqueous solution and
- treating with heat.

**18.** Electronic devices comprising a polyimide film as claimed in claim 16 as an insulating layer.

**19.** Use of the polyamic acid esters of formulae I, I' and/or I" for photosensitive resin compositions, corresponding varnishes, and photoresists, particularly for the manufacturing of electronic devices.

FIG.1A

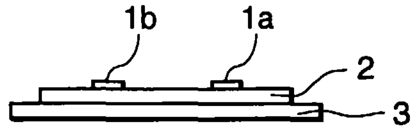


FIG.1B

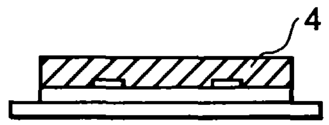


FIG.1C

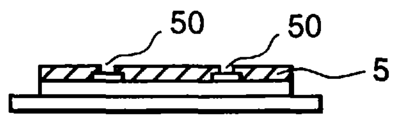


FIG.1D

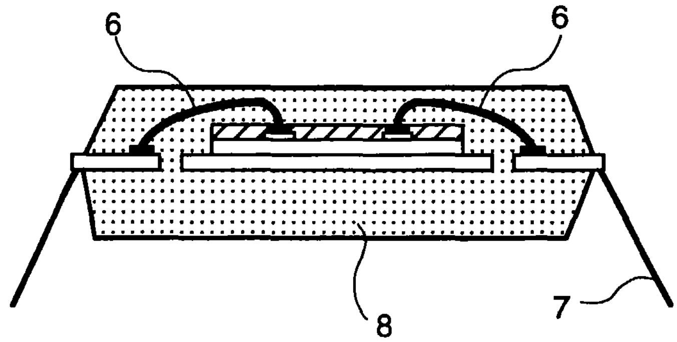

European Patent Office

# EUROPEAN SEARCH REPORT

Application Number
EP 97 10 8529

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A,D | PATENT ABSTRACTS OF JAPAN vol. 016, no. 476 (P-1430), 5 October 1992 & JP 04 168441 A (NISSAN CHEM IND LTD), 16 June 1992, * abstract * | 1-19 | G03F7/023 C08G73/10 |
| A | PATENT ABSTRACTS OF JAPAN vol. 018, no. 182 (C-1184), 29 March 1994 & JP 05 339373 A (HITACHI CHEM CO LTD), 21 December 1993, * abstract * | 1-19 | |
| A | EP 0 547 555 A (OCCIDENTAL CHEMICAL CORPORATION) * page 8; examples 1,3 * * page 9; example 18 * * claims 1,16 * | 1-19 | |

TECHNICAL FIELDS SEARCHED (Int.Cl.6)

G03F
C08G

The present search report has been drawn up for all claims

| Place of search | Date of completion of the search | Examiner |
|---|---|---|
| THE HAGUE | 2 September 1997 | J.-M. DUPART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)